# EUROPEAN PATENT APPLICATION

(11) **EP 4 672 341 A1**
(43) Date of publication of application: **31.12.2025**
(21) Application number: 24766415.4
(22) Date of filing: 04.03.2024
(51) Int. Cl.: H01L 29/778, H01L 29/20, H01L 29/06, H01L 29/43, H01L 21/335

(54) **ENHANCED HEMT DEVICE AND MANUFACTURING METHOD THEREFOR**

(30) Priority: 08.03.2023 CN 202310269611
(71) Applicant: Huawei Technologies Co., Ltd., Shenzhen, Guangdong 518129 (CN)
(72) Inventor: LIAO, Yaqiang, Shenzhen, Guangdong 518129 (CN); ZHOU, Quanbin, Shenzhen, Guangdong 518129 (CN); SHAO, Lihan, Shenzhen, Guangdong 518129 (CN)
(74) Representative: Gill Jennings & Every LLP
(86) International application number: PCT/CN2024/079962
(87) International publication number: WO 2024/183700

(57) **Abstract**

Disclosed are an enhanced HEMT device and a preparing method thereof. The device includes a substrate, and a primary epitaxial structure and a secondary epitaxial structure that are grown on the substrate. The entire device may be divided into an active region and a gate region in a horizontal direction. The primary epitaxial structure includes a channel layer and a first barrier layer. The secondary epitaxial structure includes a second barrier layer and a p-type cap layer. The first barrier layer is on the channel layer corresponding to the active region. The second barrier layer is on the channel layer corresponding to the gate region. The second barrier layer is different from the first barrier layer. According to the device preparing method in this application, both an Al component content and a thickness of the first barrier layer may be different from those of the second barrier layer, so that the barrier layers in the gate region and the active region are discrete from each other. Therefore, the device can have both a low on-resistance in the active region and a stable and regulable threshold voltage, to effectively implement an enhanced semiconductor device having high performance specifications and excellent device reliability.

## Description

### CROSS-REFERENCE TO RELATED APPLICATIONS

This application claims priority to Chinese Patent Application No. 202310269611.5, filed with the China National Intellectual Property Administration on March 8, 2023 and entitled "ENHANCED HEMT DEVICE AND PREPARING METHOD THEREOF", which is incorporated herein by reference in its entirety.

### TECHNICAL FIELD

This application relates to the field of semiconductor devices, and in particular, to an enhanced HEMT device and a preparing method thereof.

### BACKGROUND

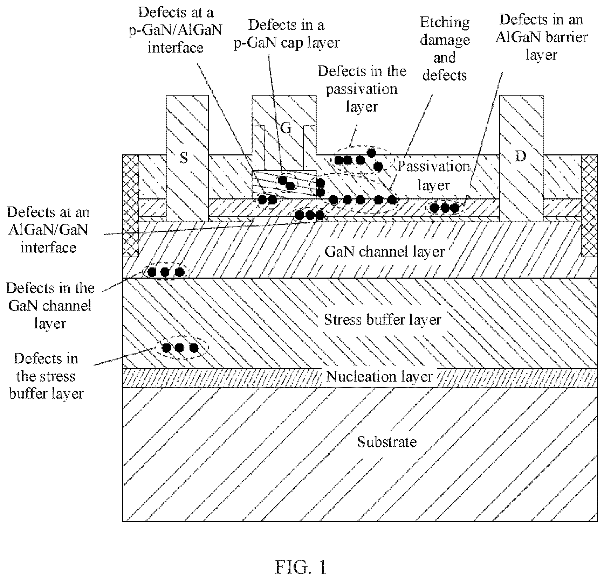

As one of typical representatives of third-generation wide-bandgap (Wide Band Gap, WBG) semiconductor materials, gallium nitride (GaN) features a wide bandgap, a high critical electric field strength, a high electron saturation velocity, excellent chemical stability, and the like. It is regarded as a semiconductor material with great potential in the future and can be used in many scenarios such as high temperatures, high radiation, high frequencies, and high power. In particular, due to spontaneous and piezoelectric polarization effect of materials, after an aluminum gallium nitride (AlGaN) material is epitaxially grown on a GaN material, a two-dimensional electron gas (Two-dimensional electron gas, 2DEG) with a high concentration and high mobility is generated at an interface between the two materials. As shown in FIG. 1, a high electron mobility transistor (High Electron Mobility Transistor, HEMT) based on the 2DEG is implemented. Because of the foregoing excellent material characteristics, an AlGaN/GaN-based HEMT (GaN HEMT for short) device usually has many advantages such as a high switching speed, high withstand voltage, low on-resistance (ON-resistance, R_{ON}), high energy density, and high temperature tolerance. Therefore, using the GaN HEMT device in a power conversion system can theoretically achieve better conversion efficiency.

The GaN HEMT device is usually a depletion-mode (normally on) device. The depletion-mode device needs a negative gate voltage for device turn-off. However, an enhanced device is more widely used in the power conversion system for the sake of circuit simplification and system failure safety. Therefore, implementation of an enhanced GaN HEMT device has been a hot research topic in academic and industrial circles for more than 10 years. However, there are still many problems in a current process of producing the enhanced GaN HEMT device. Consequently, it is difficult to further improve performance specifications of the prepared enhanced GaN HEMT device, and the device has poor reliability.

### SUMMARY

In view of this, to resolve at least one of the foregoing defects, it is necessary to provide an enhanced high electron mobility transistor (HEMT) device in this application. The enhanced HEMT device has a more stable and regulable threshold voltage, and can implement a lower on-resistance (ON-resistance, R_{ON}) of the device in an active region, reduce a loss of the device, and have higher reliability.

A first aspect of embodiments of this application provides an enhanced HEMT device. The device is divided into a gate region and an active region in a horizontal direction. The device includes a substrate, a primary epitaxial structure, and a secondary epitaxial structure. The primary epitaxial structure includes a channel layer on a surface of the substrate and a first barrier layer on a surface of the channel layer corresponding to the active region. The first barrier layer and the channel layer form a heterojunction structure having a two-dimensional electron gas. The secondary epitaxial structure includes a second barrier layer on a surface of the channel layer corresponding to the gate region and a p-type cap layer on a surface of the second barrier layer. The second barrier layer is different from the first barrier layer.

Further, the first barrier layer and the second barrier layer have at least one of the following relationships: An Al component content of the first barrier layer is higher than an Al component content of the second barrier layer; and a thickness of the first barrier layer is greater than a thickness of the second barrier layer.

The first barrier layer in the active region is formed through primary epitaxy, and then the second barrier layer that is in the gate region and different from the first barrier layer is formed through secondary epitaxy. The first barrier layer and the second barrier layer are separately disposed. The thickness and Al component content of the first barrier layer can be adjusted independently from those of the second barrier layer, achieving high flexibility. A low Al component content (and further a small thickness) of the second barrier layer corresponding to the gate region and a high Al component concentration (and further a large thickness) of the first barrier layer corresponding to the active region may be implemented, so that the enhanced HEMT device can implement a lower on-resistance in the active region and reduce a loss of the enhanced HEMT device while ensuring a stable and regulable threshold voltage, to obtain an enhanced HEMT device having higher performance specifications and reliability.

With reference to the first aspect, in some possible embodiments, the first barrier layer is a nitride barrier layer. Its specific material includes one or a combination of more of AlGaN, AlInN, InGaN, AlInGaN, ScAlN, AlN, and the like. Specifically, the first barrier layer may be a stacked structure of the foregoing plurality of materials. The second barrier layer is a nitride barrier layer. Its specific material includes one or a combination of more of AlGaN, AlInN, InGaN, AlInGaN, ScAlN, AlN, and the like. Specifically, the second barrier layer may be a stacked structure of the foregoing plurality of materials.

Further, the Al component content of the first barrier layer ranges from 1% to 40%, and further 20% to 40%. The Al component content of the first barrier layer is a mole percentage. For example, the Al component content of the first barrier layer may be 1%, 5%, 10%, 15%, 20%, 25%, 30%, 35%, 40%, or a value between any two of the foregoing values.

The Al component content of the first barrier layer affects a 2DEG concentration in the active region. Increasing the Al component content of the first barrier layer enhances polarization effect of the first barrier layer. This helps increase the 2DEG concentration in the active region, to reduce an on-resistance of the enhanced HEMT device.

Further, the thickness of the first barrier layer ranges from 1 nm to 50 nm, and further 20 nm to 50 nm. For example, the thickness of the first barrier layer may be 1 nm, 5 nm, 10 nm, 15 nm, 20 nm, 25 nm, 30 nm, 35 nm, 40 nm, 45 nm, 50 nm, or a value between any two of the foregoing values.

In addition to a fact that the Al component content affects the 2DEG concentration in the active region, the thickness of the first barrier layer also affects the 2DEG concentration in the active region. An increase in the thickness of the first barrier layer leads to an increase in the 2DEG concentration in the active region. However, an excessively large thickness of the first barrier layer causes strain relaxation, reduces piezoelectric polarization effect, and slows down the increase in the 2DEG concentration in the active region. Therefore, in this embodiment, the 2DEG concentration in the active region can be further increased by adjusting the thickness of the first barrier layer to be within the foregoing range.

Further, the Al component content of the second barrier layer ranges from 1% to 30%, and further from 10% to 25%. The Al component content of the second barrier layer is a mole percentage. For example, the Al component content of the second barrier layer may be 1%, 5%, 10%, 15%, 20%, 25%, 30%, or a value between any two of the foregoing values.

A lower Al component content of the second barrier layer indicates a lower concentration of a 2DEG that can be formed in the gate region. By controlling the Al component content of the second barrier layer to be within the foregoing range, the p-type cap layer can more easily deplete the 2DEG in the gate region, to pinch off a gate channel and obtain a stable and regulable threshold voltage. In this way, an enhanced device function is achieved.

Further, the thickness of the second barrier layer ranges from 1 nm to 40 nm, and further 10 nm to 30 nm. For example, the thickness of the second barrier layer may be 1 nm, 5 nm, 10 nm, 15 nm, 20 nm, 25 nm, 30 nm, 35 nm, 40 nm, or a value between any two of the foregoing values.

A smaller thickness of the second barrier layer indicates a lower concentration of a 2DEG that can be formed in the gate region. The p-type cap layer can more easily deplete the 2DEG in the gate region, to pinch off a gate channel and obtain a stable and regulable threshold voltage. In this way, an enhanced device function is achieved.

In addition, in this embodiment, the Al component contents and thicknesses of the first barrier layer and the second barrier layer may be flexibly adjusted within the foregoing ranges, to increase the 2DEG concentration in the active region and reduce the 2DEG concentration in the gate region. In this way, the enhanced HEMT device can implement a lower on-resistance in the active region while ensuring a stable and regulable threshold voltage.

With reference to the first aspect, in some possible embodiments, the p-type cap layer is a p-type nitride cap layer. Its specific material includes one or a combination of more of GaN, AlGaN, InGaN, AlInGaN, and the like. The channel layer is a nitride channel layer. Its specific material includes one or a combination of more of GaN, InN, AlN, AlGaN, and the like.

With reference to the first aspect, in some possible embodiments, the device further includes a first passivation layer on a surface of the first barrier layer. Further, a material of the first passivation layer includes one or a combination of more of SiNₓ, SiO₂, Al₂O₃, AlOₓN_{y}, GaOₓ, AlN, GaOₓN_{y}, and the like.

The high-quality first passivation layer is first introduced on the surface of the first barrier layer, and then the second barrier layer is formed through secondary epitaxy, so that a density of states at an interface between the first barrier layer and the first passivation layer can be effectively reduced. In addition, the first passivation layer plays a role of a blocking layer. First, this avoids that a 2DEG is depleted because an acceptor dopant diffuses outward during epitaxial growth of the p-type cap layer, to help further implement a low on-resistance of the enhanced HEMT device. Second, this can avoid etching damage to the first barrier layer in a process of removing the p-type cap layer in the active region in a conventional process flow, to improve performance and reliability of the enhanced HEMT device.

With reference to the first aspect, in some possible embodiments, the device further includes a second passivation layer on a surface of the first passivation layer. A material of the second passivation layer includes one or a combination of more of SiNₓ, SiO₂, Al₂O₃, AlOₓN_{y}, GaOₓ, AlN, GaOₓN_{y}, and the like.

With reference to the first aspect, in some possible embodiments, the primary epitaxial structure further includes a nucleation layer and a stress buffer layer that are sequentially stacked from bottom to top on the surface of the substrate. The channel layer is on a surface that is of the stress buffer layer and that is away from the nucleation layer. Further, the nucleation layer is a nitride nucleation layer, and the stress buffer layer is a nitride stress buffer layer.

The nucleation layer and the stress buffer layer play an important role in crystal quality, surface morphology, and an electrical characteristic of a formed heterojunction. Properly disposing the nucleation layer and the stress buffer layer can reduce defects and stresses in the channel layer, the first barrier layer, and the second barrier layer, so that the subsequently formed heterojunction has good crystal quality and surface morphology.

A second aspect of embodiments of this application provides a preparing method for an enhanced HEMT device. The device is divided into a gate region and an active region in a horizontal direction. The preparing method includes:
sequentially forming a channel layer and an intermediate barrier layer from bottom to top on a surface of a substrate;
removing the intermediate barrier layer in the gate region to expose the channel layer, where the intermediate barrier layer in the active region constitutes a first barrier layer, the channel layer and the first barrier layer constitute a primary epitaxial structure, and the channel layer and the first barrier layer form a heterojunction structure having a two-dimensional electron gas;
forming a second barrier layer different from the first barrier layer on a surface of the exposed channel layer in the gate region; and
forming a p-type cap layer on a surface of the second barrier layer to obtain the device, where the second barrier layer and the p-type cap layer constitute a secondary epitaxial structure.

In a preparing process of the enhanced HEMT device provided in embodiments of this application, the first barrier layer in the active region and the second barrier layer in the gate region are separately formed through two epitaxies, so that an Al component content or a thickness of the first barrier layer can be effectively adjusted independently from that of the second barrier layer without mutual interference. This helps implement a lower on-resistance in the active region and reduce a loss of the enhanced HEMT device while ensuring that the enhanced HEMT device has a stable and regulable threshold voltage. The enhanced HEMT device is simple to prepare and easy to implement. The first barrier layer is not etched, so that there are no problems such as excessive etching on and etching damage to the first barrier layer. This helps improve performance specifications and reliability of the enhanced HEMT device.

Further, the first barrier layer and the second barrier layer have at least one of the following relationships: An Al component content of the first barrier layer is higher than an Al component content of the second barrier layer; and a thickness of the first barrier layer is greater than a thickness of the second barrier layer.

With reference to the second aspect, in some possible embodiments, before removing the intermediate barrier layer in the gate region, the preparing method further includes:
forming a first passivation layer on a surface of the intermediate barrier layer; and
removing the first passivation layer in the gate region.

The high-quality first passivation layer is first introduced on the surface of the first barrier layer, and then the second barrier layer is formed through secondary epitaxy, so that a density of states at an interface between the first barrier layer and the first passivation layer can be effectively reduced. In addition, the first passivation layer plays a role of a blocking layer. First, this avoids that a 2DEG is depleted because an acceptor dopant diffuses outward during epitaxial growth of the p-type cap layer, to help further implement a low on-resistance of the enhanced HEMT device. Second, this can avoid etching damage to the first barrier layer in a process of removing the p-type cap layer in the active region in a conventional process flow, to improve performance and reliability of the enhanced HEMT device.

With reference to the second aspect, in some possible embodiments, a method for forming the first passivation layer may include metalorganic chemical vapor deposition (Metal-Organic Chemical Vapour Deposition, MOCVD), chemical vapor deposition (Chemical Vapour Deposition, CVD), sputter deposition (Sputter Deposition), atomic layer deposition (Atomic Layer Deposition, ALD), or the like. Further, the method for forming the first passivation layer may be an MOCVD process.

Through the foregoing process, the first passivation layer may be formed on the surface of the first barrier layer in primary epitaxy, to play a role of a blocking layer. Especially, the first passivation layer formed through the MOCVD process has a low density of states at the interface and higher quality, to improve the performance and reliability of the enhanced HEMT device.

With reference to the second aspect, in some possible embodiments, after removing the intermediate barrier layer in the gate region to expose the channel layer, the preparing method further includes:
repairing the surface of the exposed channel layer.

Repairing the surface of the exposed channel layer in the gate region can improve quality of the second barrier layer and the p-type cap layer in secondary epitaxy, and reduce generated defects, to improve the performance and reliability of the enhanced HEMT device.

With reference to the second aspect, in some possible embodiments, after forming the p-type cap layer, the preparing method further includes:
performing annealing to activate an acceptor dopant in the p-type cap layer.

After performing annealing to activate the acceptor dopant in the p-type cap layer, the preparing method further includes:
forming a second passivation layer on surfaces of the first passivation layer and the p-type cap layer.

With reference to the second aspect, in some possible embodiments, before forming the channel layer on the surface of the substrate, the preparing method further includes:
forming a nucleation layer on the surface of the substrate; and
forming a stress buffer layer on a surface of the nucleation layer.

The channel layer is formed on a surface of the stress buffer layer.

The nucleation layer and the stress buffer layer play an important role in crystal quality, surface morphology, and an electrical characteristic of a formed heterojunction. Properly disposing the nucleation layer and the stress buffer layer can reduce defects and stresses in the channel layer, the first barrier layer, and the second barrier layer, so that the subsequently formed heterojunction has good crystal quality and surface morphology.

### BRIEF DESCRIPTION OF DRAWINGS

FIG. 1 is a diagram of an enhanced HEMT device in the conventional technology;
(1) to (4) in FIG. 2 are diagrams of a partial preparing process of the enhanced HEMT device in FIG. 1;
FIG. 3 is a diagram of a structure of an enhanced HEMT device according to an embodiment of this application;
FIG. 4 shows a circuit topology of a half-bridge LLC resonant converter in which an enhanced HEMT device is used in a functional switching device according to an embodiment of this application;
FIG. 5A is a diagram of a structure of a simulated device according to an embodiment of this application;
FIG. 5B is a diagram of a simulation result obtained after a change in an Al component content of a first barrier layer in the simulated device in FIG. 5A;
FIG. 6 is a flowchart of a preparing method for an enhanced HEMT device according to an embodiment of this application;
FIG. 7A is a first diagram of a preparing process of an enhanced HEMT device according to an embodiment of this application;
FIG. 7B is a second diagram of a preparing process of an enhanced HEMT device according to an embodiment of this application;
FIG. 7C is a third diagram of a preparing process of an enhanced HEMT device according to an embodiment of this application;
FIG. 7D is a fourth diagram of a preparing process of an enhanced HEMT device according to an embodiment of this application;
FIG. 7E is a fifth diagram of a preparing process of an enhanced HEMT device according to an embodiment of this application; and
FIG. 7F is a sixth diagram of a preparing process of an enhanced HEMT device according to an embodiment of this application.

### Reference numerals of main elements

| | |
|---|---|
| Enhanced HEMT device | 100 |
| Substrate | 1 |
| Gate region | 11 |
| Active region | 12 |
| Source-side active region | 121 |
| Drain-side active region | 122 |
| Nucleation layer | 2 |
| Stress buffer layer | 3 |
| Channel layer | 4 |
| First barrier layer | 5 |
| Window | 51 |
| First passivation layer | 6 |
| Second barrier layer | 7 |
| p-type cap layer | 8 |
| Second passivation layer | 9 |
| Primary epitaxial structure | 10 |
| Secondary epitaxial structure | 20 |
| Gate | 30 |
| Source | 40 |
| Drain | 50 |
| Intermediate barrier layer | 60 |
| Isolation layer | 70 |

### DESCRIPTION OF EMBODIMENTS

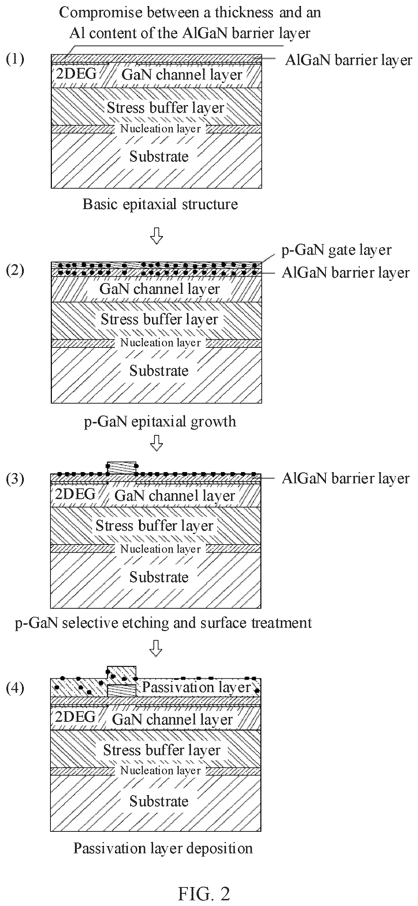

Currently, a common structure of an enhanced gallium nitride (GaN) high electron mobility transistor (High Electron Mobility Transistor, HEMT) device is a p-GaN gate structure (p-GaN gate HEMT), as shown in FIG. 1. For a p-GaN gate HEMT device, a p-GaN cap layer may deplete a two-dimensional electron gas (Two-dimensional electron gas, 2DEG) below an aluminum gallium nitride (AlGaN) barrier layer to turn off the device at zero gate bias. In this way, an enhanced device is implemented. However, it is difficult to further improve performance specifications of the enhanced HEMT device prepared through this method, and the device has poor reliability. This limits wide application of the p-GaN gate HEMT device. It is found through research that difficulty in improving performance specifications and reliability of an existing p-GaN gate structure is mainly due to the following reasons.
(1) As shown in (1) to (4) in FIG. 2, for the p-GaN gate HEMT device, a 2DEG concentration at an AlGaN/GaN heterojunction is determined by an Al component content and a thickness of an AlGaN barrier layer. Designing the barrier layer to have a high Al component content and increasing the thickness of the AlGaN barrier layer increase the 2DEG concentration and decrease an on-resistance (ON-resistance, R_{ON}) of the prepared enhanced HEMT device. For the p-GaN gate HEMT device, to ensure that the p-GaN layer can completely deplete the 2DEG and obtain an appropriate threshold voltage (usually greater than 1 V) at zero gate bias, an Al component concentration of the AlGaN barrier layer cannot be designed to be excessively high, and the thickness of the AlGaN barrier layer cannot be designed to be excessively large. However, lowering the Al component content of the AlGaN barrier layer or reducing the thickness of the AlGaN barrier layer limits a 2DEG concentration in an active region and increases the on-resistance. Therefore, in an existing epitaxial design process of the AlGaN barrier layer, a compromise usually needs to be made between the Al component content of the AlGaN barrier layer and the thickness of the AlGaN barrier layer. Consequently, the p-GaN gate HEMT device cannot achieve better performance specifications. In addition, there is a larger lattice mismatch between the AlGaN barrier layer with an excessively high Al component content and a GaN channel layer, and more defects may be introduced. These defects may cause a failure during device operation, to reduce reliability of the device.
(2) As shown in (1) to (4) in FIG. 2, a process of forming the p-GaN cap layer of the p-GaN gate HEMT device is as follows: First, the p-GaN cap layer is grown on a surface of the AlGaN barrier layer. Then, the p-GaN cap layer in the active region is removed through selective etching, to restore a 2DEG in the active region and retain the p-GaN cap layer in a gate region. During continuous epitaxial growth of the p-GaN cap layer, an acceptor dopant (for example, a Mg element) easily diffuses to the AlGaN barrier layer, to form a new "defect". This reduces the 2DEG concentration in the active region, to increase an on-resistance in the active region and reduce the reliability of the device (for example, degrade a dynamic resistance). In addition, in an existing process flow, the p-GaN cap layer is selectively etched. First, to ensure that the p-GaN cap layer in the active region is completely etched, the AlGaN barrier layer with a specific thickness is excessively etched. This reduces the thickness of the AlGaN barrier layer in the active region, to reduce the 2DEG concentration in the active region and increase the on-resistance of the device. Second, an etching process also brings many problems of etching damage and defects, resulting in a reliability problem of the device.

In view of this, embodiments of this application provide an enhanced high electron mobility transistor (HEMT) device. The enhanced HEMT device may be widely used in the field of power electronics, and may be specifically used in a power switching device needed in a field such as in-vehicle, terminals, wireless, or the like. The enhanced HEMT device has a more stable and regulable threshold voltage, and can implement a lower on-resistance of the device in an active region, reduce a loss of the device, and have higher reliability.

The following describes embodiments of this application with reference to the accompanying drawings in embodiments of this application.

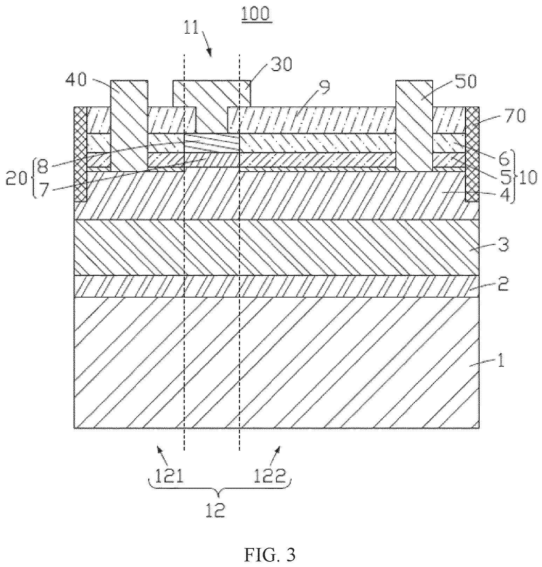

With reference to FIG. 3, embodiments of this application provide an enhanced HEMT device 100. The enhanced HEMT device 100 includes a substrate 1, a primary epitaxial structure 10 grown on a surface of the substrate 1, a secondary epitaxial structure 20, a gate 30, a source 40, and a drain 50. The enhanced HEMT device 100 is divided into a gate region 11 and an active region 12 in a horizontal direction. The gate region 11 is approximately a region in which the gate 30 is located. The active region 12 is approximately a region between the gate 30 and outer edges that are of the source 40 and the drain 50 and that are away from the gate 30. The active region 12 includes a source-side active region 121 and a drain-side active region 122. The source 40 is located in the source-side active region 121. The drain 50 is located in the drain-side active region 122.

The primary epitaxial structure 10 includes a channel layer 4 on the surface of the substrate 1 and a first barrier layer 5 on a surface of the channel layer 4 corresponding to the active region 12. The first barrier layer 5 and the channel layer 4 form a heterojunction structure having a two-dimensional electron gas (2DEG). The secondary epitaxial structure 20 includes a second barrier layer 7 that is on a surface of the channel layer 4 corresponding to the gate region 11 and that is different from the first barrier layer 5, and a p-type cap layer 8 on a surface of the second barrier layer 7. The p-type cap layer 8 is configured to deplete a two-dimensional electron gas (2DEG) formed by the second barrier layer 7 and the channel layer 4. In addition, the gate 30 is on a surface of the p-type cap layer 8. The source 40 penetrates the first barrier layer 5 in the source-side active region 121, and is disposed on the surface of the channel layer 4. Alternatively, the source 40 may be directly disposed on a surface of the first barrier layer 5. The drain 50 penetrates the first barrier layer 5 in the drain-side active region 122, and is disposed on the surface of the channel layer 4. Alternatively, the drain 50 may be directly disposed on the surface of the first barrier layer 5.

In embodiments of this application, a side wall that is of the first barrier layer 5 and that is close to the gate region 11 encloses a window 51. The second barrier layer 7 is separately formed in the window 51. In this way, the first barrier layer 5 and the second barrier layer 7 can be discrete from each other in structure and can be separately formed, so that Al component contents and thicknesses of the first barrier layer 5 and the second barrier layer 7 can be separately adjusted. Specifically, the first barrier layer 5 in primary epitaxy and the second barrier layer 7 in secondary epitaxy may have at least one of the following relationships: The Al component content of the first barrier layer 5 is higher than the Al component content of the second barrier layer 7; and the thickness of the first barrier layer 5 is greater than the thickness of the second barrier layer 7. It may be understood that a size of the window 51 in the horizontal direction (namely, a size of the second barrier layer 7 in the horizontal direction) may be determined based on an actual size of the gate 30.

The substrate 1 includes but is not limited to any one of a silicon substrate, a sapphire substrate, a silicon carbide substrate, a free-standing gallium nitride substrate, or an aluminum nitride substrate.

The enhanced HEMT device 100 further includes a nucleation layer 2 on the surface of the substrate 1 and a stress buffer layer 3 on a surface of the nucleation layer 2. The nucleation layer 2 may be a nitride nucleation layer, and specifically includes but is not limited to at least one of AlN, AlGaN, GaN, and the like. The buffer layer 3 may be a nitride stress buffer layer. Specifically, a material of the stress buffer layer 3 may include but is not limited to at least one of AlN, AlGaN, GaN, and the like. The nucleation layer 2 and the stress buffer layer 3 play an important role in crystal quality, surface morphology, and an electrical characteristic of a formed heterojunction. Properly disposing the nucleation layer 2 and the buffer layer 3 can reduce defects and stresses in the channel layer 4, the first barrier layer 5, and the second barrier layer 7, so that the subsequently formed heterojunction has good crystal quality and surface morphology.

A material of the channel layer 4 may include but is not limited to one or a combination of more of GaN, InN, AlN, AlGaN, and the like. In some embodiments, the material of the channel layer 4 may be GaN. The p-type cap layer 8 may be a p-type nitride cap layer. Its specific material may include one or a combination of more of GaN, AlGaN, InGaN, AlInGaN, and the like.

For the problem (1) in the conventional technology, with reference to FIG. 3, in embodiments of this application, the first barrier layer 5 is grown in the active region 12 through primary epitaxy. Its side wall close to the gate region 11 forms the window 51. The first barrier layer 5 and the channel layer 4 below it can form the heterojunction structure having the 2DEG. The second barrier layer 7 is formed in the window 51 in the gate region 11 through secondary epitaxy. The p-type cap layer 8 is formed on the surface of the second barrier layer 7 through secondary epitaxy. The p-type cap layer 8 can deplete the 2DEG formed by the second barrier layer 7 and the channel layer 4 below it, to pinch off a gate channel and obtain a stable and regulable threshold voltage. A concentration of a formed 2DEG directly affects an electrical characteristic of the enhanced HEMT device 100. For example, a higher 2DEG concentration in the active region 12 indicates a lower on-resistance of the enhanced HEMT device 100. A concentration of a 2DEG formed in the active region 12 is greatly affected by the Al component content of the first barrier layer 5 and the thickness of the first barrier layer 5. In addition, to ensure that the p-type cap layer 8 can completely deplete the 2DEG and obtain a stable threshold voltage (a threshold voltage of an enhanced HEMT device with a p-GaN gate structure is usually greater than 1 V) at zero gate bias, the Al component content of the second barrier layer 7 and the thickness of the second barrier layer 7 need to be adjusted. Therefore, in the enhanced HEMT device 100 provided in embodiments of this application, the first barrier layer 5 and the second barrier layer 7 can be discrete from each other in structure. In addition, the Al component content and thickness of the first barrier layer 5 do not interfere with those of the second barrier layer 7 in design. In this way, the enhanced HEMT device 100 can have a more stable and regulable threshold voltage, and can implement a lower on-resistance of the device in the active region 12 and reduce a loss of the device, so that the enhanced HEMT device 100 has higher performance specifications and reliability.

In some embodiments, the first barrier layer 5 may be a nitride barrier layer. Its specific material may include one or a combination of more of AlGaN, AlInN, InGaN, AlInGaN, ScAlN, AlN, and the like. The first barrier layer 5 contains an Al component. Specifically, the first barrier layer 5 may be a stacked structure of the foregoing plurality of materials. For example, the first barrier layer 5 may be made of AlGaN and may form an AlGaN/GaN heterojunction with the channel layer 4 made of GaN.

In some embodiments, the Al component content (for example, it may be a mole percentage of an Al element in a compound) of the first barrier layer 5 may be 1% to 40%, and further 20% to 40%. For example, the Al component content may be 1%, 5%, 10%, 15%, 20%, 25%, 30%, 35%, 40%, or a value between any two of the foregoing values. The Al component content of the first barrier layer 5 affects the 2DEG concentration in the active region 12. Increasing the Al component content of the first barrier layer 5 enhances polarization effect of the first barrier layer 5. This helps increase the 2DEG concentration in the active region 12, to reduce the on-resistance of the enhanced HEMT device 100. Therefore, designing the first barrier layer 5 to have a high Al component content helps reduce the on-resistance of the enhanced HEMT device 100 and increase an on-current. In this embodiment, the Al component content of the first barrier layer 5 is controlled to be within a range of 1% to 40%. This helps increase the 2DEG concentration in the active region 12, to reduce the on-resistance of the enhanced HEMT device 100.

In some embodiments, the thickness of the first barrier layer 5 may be 1 nm to 50 nm, and further 20 nm to 50 nm. For example, the thickness of the first barrier layer 5 may be 1 nm, 5 nm, 10 nm, 15 nm, 20 nm, 25 nm, 30 nm, 35 nm, 40 nm, or a value between any two of the foregoing values. In addition to a fact that the Al component content affects the 2DEG concentration in the active region 12, the thickness of the first barrier layer 5 also affects the 2DEG concentration in the active region 12. An increase in the thickness of the first barrier layer 5 leads to an increase in the 2DEG concentration in the active region 12. However, an excessively large thickness of the first barrier layer 5 causes strain relaxation, reduces piezoelectric polarization effect, and slows down the increase in the 2DEG concentration in the active region 12. Therefore, in this embodiment, the 2DEG concentration in the active region 12 can be further increased by adjusting the thickness of the first barrier layer 5 to be within the foregoing range.

In some embodiments, the second barrier layer 7 may be a nitride barrier layer. Its specific material may include one or a combination of more of AlGaN, AlInN, InGaN, AlInGaN, ScAlN, and AlN. The second barrier layer 7 contains an Al component. Specifically, the second barrier layer 7 may be a stacked structure of the foregoing plurality of materials. In some embodiments, the second barrier layer 7 may be made of AlGaN and the p-type cap layer 8 may be made of p-GaN, so that an enhanced HEMT device with a p-GaN gate structure may be constituted.

In some embodiments, the Al component content of the second barrier layer 7 may be 1% to 30%, and further 10% to 25%. For example, the Al component content may be 1%, 5%, 10%, 15%, 20%, 25%, 30%, or a value between any two of the foregoing values. A lower Al component content of the second barrier layer 7 indicates a lower concentration of a 2DEG that can be formed in the gate region 11. By controlling the Al component content of the second barrier layer 7 to be within the foregoing range, the p-type cap layer 8 can more easily deplete the 2DEG in the gate region, to pinch off a gate channel and obtain a stable and regulable threshold voltage. In this way, an enhanced device function is achieved.

In some embodiments, the thickness of the second barrier layer 7 may be 1 nm to 40 nm, and further 10 nm to 30 nm. For example, the thickness of the second barrier layer 7 may be 1 nm, 5 nm, 10 nm, 15 nm, 20 nm, 25 nm, 30 nm, 35 nm, 40 nm, or a value between any two of the foregoing values. A smaller thickness of the second barrier layer 7 indicates a lower 2DEG concentration in the gate region 11. The 2DEG concentration in the gate region 11 can be further reduced by controlling the thickness of the second barrier layer 7 to be within the foregoing range, so that the p-type cap layer 8 can more easily deplete the 2DEG in the gate region 11, to pinch off a gate channel and obtain a stable and regulable threshold voltage. In this way, an enhanced device function is achieved.

For the problem (2) in the conventional technology, with reference to FIG. 3, in embodiments of this application, the primary epitaxial structure 10 may further include a first passivation layer 6 on the surface of the first barrier layer 5. In other words, the first passivation layer 6 is first introduced on the surface of the first barrier layer 5 through primary epitaxy. The first passivation layer 6 is a high-quality passivation layer, so that a density of states at an interface between the first barrier layer 5 and the first passivation layer 6 can be effectively reduced. In addition, the first passivation layer 6 plays a role of a blocking layer. The first passivation layer 6 is formed before the second barrier layer 7 is formed through secondary epitaxy. First, this avoids that a 2DEG is depleted because an acceptor dopant diffuses outward during epitaxial growth of the p-type cap layer 8, to help further implement a low on-resistance of the enhanced HEMT device 100. Second, this can avoid etching damage to the first barrier layer 5 in a process of removing the p-type cap layer 8 in the active region in a conventional process flow, to improve performance and reliability of the enhanced HEMT device 100.

In some embodiments, the first passivation layer 6 may be a high-quality SiNₓ, SiO₂, Al₂O₃, AlOₓN_{y}, GaOₓ, or GaOₓN_{y} passivation layer. A method for forming the first passivation layer 6 may be metalorganic chemical vapor deposition (Metal-Organic Chemical Vapour Deposition, MOCVD), chemical vapor deposition (Chemical Vapour Deposition, CVD), sputter deposition (Sputter Deposition), atomic layer deposition (Atomic Layer Deposition, ALD), or the like. Specifically, the first passivation layer 6 may be a silicon nitride passivation layer formed through a high-quality passivation technology such as a metalorganic vapor-phase epitaxy (MOCVD) process.

In some embodiments, a thickness of the first passivation layer 6 may be 10 nm to 100 nm, and further 50 nm to 100 nm. For example, the thickness of the first passivation layer 6 may be 10 nm, 20 nm, 30 nm, 40 nm, 50 nm, 60 nm, 70 nm, 80 nm, 90 nm, 100 nm, or a value between any two of the foregoing values. The thickness of the first passivation layer 6 is designed based on the thicknesses of the second barrier layer 7 and the p-type cap layer 8. The thickness of the first passivation layer 6 cannot be designed to be excessively large. Otherwise, growth of the second barrier layer 7 and the p-type cap layer 8 is affected. In addition, it cannot be excessively small. Otherwise, the performance and reliability of the enhanced HEMT device 100 cannot be improved.

With reference to FIG. 3, the enhanced HEMT device 100 may further include a second passivation layer 9 on a surface of the first passivation layer 6. A material of the second passivation layer 9 may include but is not limited to at least one of SiNₓ, SiO₂, Al₂O₃, AlOₓN_{y}, GaOₓ, GaOₓN_{y}, and the like.

In embodiments of this application, the first barrier layer 5 with a high Al component content in the active region 12 is formed through primary epitaxy, and then the second barrier layer 7 with a low Al component content in the gate region 11 is formed through secondary epitaxy. The thickness and Al component content of the first barrier layer 5 can be adjusted independently from those of the second barrier layer 7, achieving high flexibility. A low Al component content (and further a small thickness) of the second barrier layer 7 in the gate region 11 and a high Al component concentration (and further a large thickness) of the first barrier layer 5 in the active region 12 may be implemented, so that the enhanced HEMT device 100 can implement a lower on-resistance in the active region 12 and reduce a loss of the enhanced HEMT device 100 while ensuring a stable and regulable threshold voltage, to obtain an enhanced HEMT device 100 having higher performance specifications and reliability.

The high-quality first passivation layer 6 is first introduced on the surface of the first barrier layer 5 through primary epitaxy, so that the density of states at the interface between the first barrier layer 5 and the first passivation layer 6 can be effectively reduced. In addition, the first passivation layer 6 plays a role of a blocking layer. First, this avoids that a 2DEG is depleted because an acceptor dopant diffuses outward during epitaxial growth of the p-type cap layer 8, to help further implement a low on-resistance of the enhanced HEMT device 100. Second, this can avoid etching damage to the first barrier layer 5 in a process of removing the p-type cap layer 8 in the active region in a conventional process flow, to improve performance and reliability of the enhanced HEMT device 100.

The following further describes the foregoing enhanced HEMT device 100 through specific embodiments.

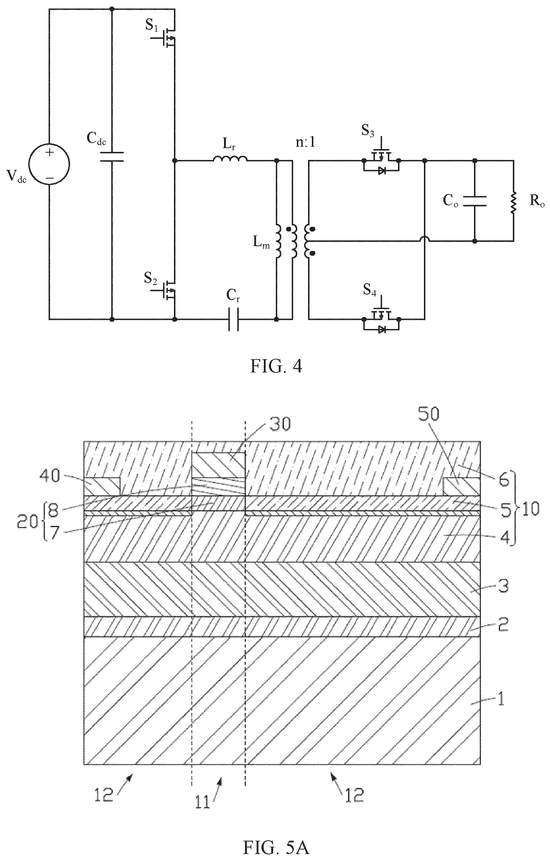

As shown in FIG. 4, the enhanced HEMT device 100 provided in embodiments of this application may be used in a power switching device needed in a field such as in-vehicle, terminals, wireless, or the like. In an off state, it can withstand a high voltage, and can be turned on in an extremely short time. In addition, a large on-current can be implemented due to a low on-resistance. Herein, a circuit topology of a half-bridge LLC resonant converter is used as an example. As shown in FIG. 4, at a high frequency, a size of a passive resonant element is greatly reduced, and a power density is increased. However, under this condition, selection of power switching devices S₁ and S₂ needs to be considered, to achieve better efficiency and power density. From this perspective, compared with Si and SiC power MOSFET devices, at a same on-resistance, a GaN HEMT device has a significantly reduced output capacitance Cₒₛₛ and gate charge Q_{g}. This can effectively reduce a drive loss and turn-on and turn-off time. Therefore, the GaN HEMT device can be regarded as an excellent choice during LLC topology application. In addition, a GaN HEMT power device whose reverse recovery charge Qᵣᵣ is zero has higher device reliability, to avoid an LLC failure risk. Therefore, the GaN HEMT power device has higher potential value in terms of efficiency and power density.

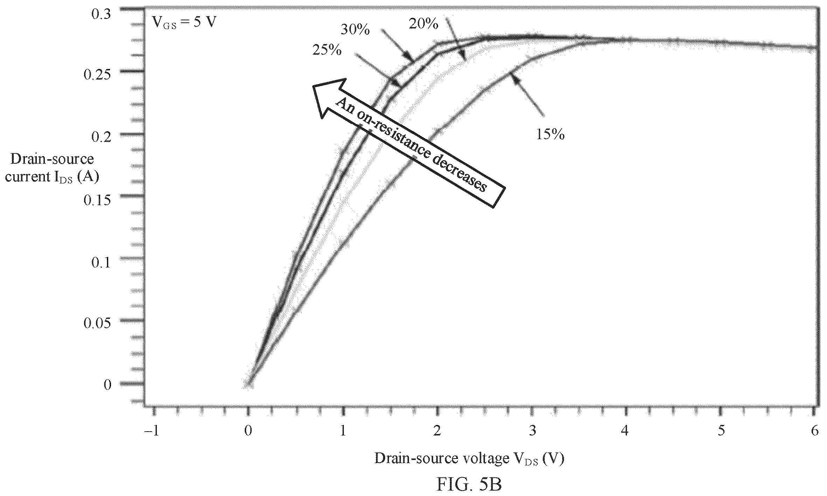

Technical effect brought by the enhanced HEMT device provided in the foregoing embodiments may be verified through Silvaco TCAD device simulation. A structure of a simulated device is shown in FIG. 5A. To ensure proper simulation, all simulation parameters except an Al component content of an AlGaN barrier layer in an active region are kept consistent. In particular, in the structure shown in the figure, an Al component content of a second barrier layer 7 corresponding to a gate region 12 also remains unchanged. A threshold voltage is approximately 1.2 V. As shown in FIG. 5B, when an Al component content of a first barrier layer 5 corresponding to an active region 12 is changed from 15% to 20%, 25%, or 30%, a simulation result shows that at a specific gate voltage (for example, the gate voltage V_{GS} is 5 V), an on-resistance (R_{ON}) is significantly reduced, and an on-current (I_{DS}) is increased.

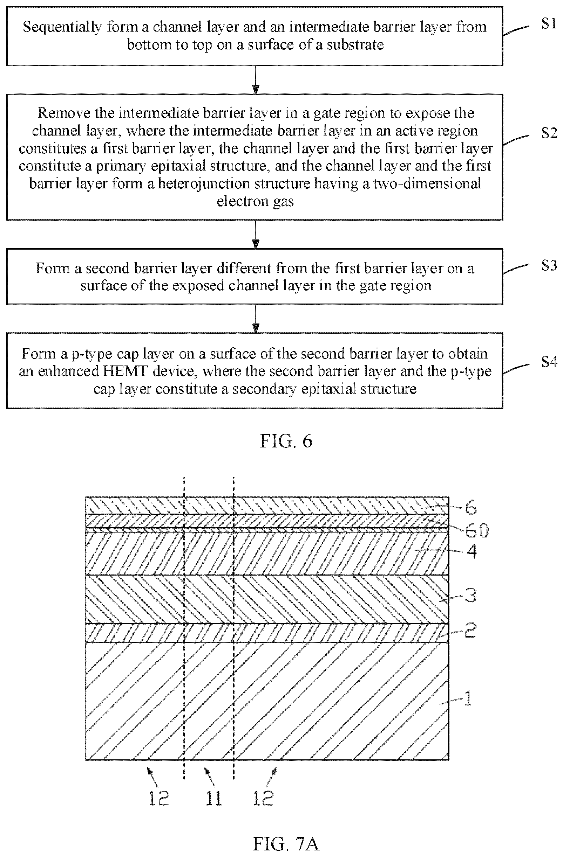

As shown in FIG. 6, embodiments of this application further provide a preparing method for the foregoing enhanced HEMT device 100, including the following steps (the following steps may be understood with reference to FIG. 7A to FIG. 7F).

S1: As shown in FIG. 7A, sequentially form the channel layer 4 and an intermediate barrier layer 60 from bottom to top on the surface of the substrate 1.

The channel layer 4 and the intermediate barrier layer 60 may be formed on the surface of the substrate 1 through epitaxial growth. The intermediate barrier layer 60 is used to form the subsequent first barrier layer 5. Therefore, for a material and thickness of the intermediate barrier layer 60, refer to the foregoing first barrier layer 5. Details are not described herein again.

In some embodiments, in step S1, before the channel layer 4 is formed on the surface of the substrate 1, the nucleation layer 2 and the buffer layer 3 may be epitaxially grown in sequence from bottom to top on the surface of the substrate 1. Next, the channel layer 4 is epitaxially grown on the surface of the buffer layer 3. Then, the intermediate barrier layer 60 is epitaxially grown on the surface of the channel layer 4.

In some embodiments, after step S1, the first passivation layer 6 may be further formed on a surface of the intermediate barrier layer 60. The first passivation layer 6 may be formed through metalorganic chemical vapor deposition (Metal-Organic Chemical Vapour Deposition, MOCVD), chemical vapor deposition (Chemical Vapour Deposition, CVD), sputter deposition (Sputter Deposition), atomic layer deposition (Atomic Layer Deposition, ALD), or the like, and may be specifically grown on the surface of the intermediate barrier layer 60 through high-quality epitaxial growth (for example, an MOCVD process). This helps obtain the high-quality first passivation layer 6. For a material, a thickness, and beneficial effects of the high-quality first passivation layer 6, refer to the foregoing description. Details are not described herein again.

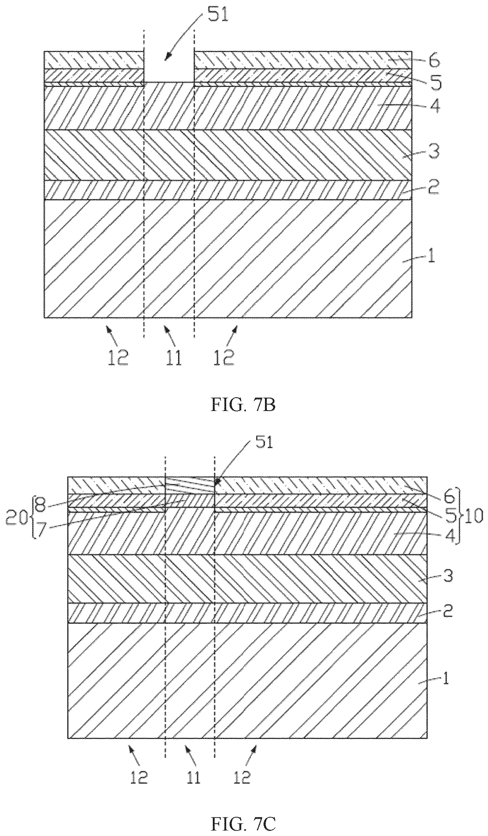

S2: As shown in FIG. 7B, remove the intermediate barrier layer 60 in the gate region 11 to expose the channel layer 4. The intermediate barrier layer 60 in the active region 12 constitutes the first barrier layer 5. The channel layer 4 and the first barrier layer 5 constitute the primary epitaxial structure 10. The channel layer 4 and the first barrier layer 5 form a heterojunction structure having a two-dimensional electron gas.

In some embodiments, before step S2, the preparing method further includes: Form the first passivation layer 6 on the surface of the intermediate barrier layer 60. When the first passivation layer 6 exists, in a process of removing the intermediate barrier layer 60 in the gate region 11, the first passivation layer 6 in the gate region 11 further needs to be removed in advance, to form the window 51. Specifically, the intermediate barrier layer 60 and the first passivation layer 6 in the gate region 11 may be completely etched through patterning and selective etching, to form the window 51.

In some embodiments, after step S2, after the first passivation layer 6 and the intermediate barrier layer 60 in the gate region 11 are removed, the surface of the exposed channel layer 4 in the gate region 11 further needs to be repaired, to reduce defects on the surface of the channel layer 4, improve lattice quality of the subsequently formed second barrier layer 7, and further improve performance and reliability of the enhanced HEMT device. A surface treatment manner includes an atomic layer etching (ALE) process, a digital etching process, an MOCVD thermal treatment process, or the like.

S3: As shown in FIG. 7C, form the second barrier layer 7 different from the first barrier layer 5 on the surface of the exposed channel layer 4 in the gate region 11.

The first barrier layer 5 and the second barrier layer 7 may be specifically different in Al component content, thickness, or both Al component content and thickness. For details, refer to the foregoing description. Details are not described herein again.

The second barrier layer 7 is epitaxially grown on the surface of the channel layer 4 in the window 51 in the gate region 11. For the material and thickness of the second barrier layer 7, refer to the foregoing description. Details are not described herein again. The thickness of the second barrier layer 7 may be adjusted based on an actual requirement.

S4: As shown in FIG. 7C to FIG. 7F, with reference to FIG. 3, form the p-type cap layer 8 on the surface of the second barrier layer 7 to obtain the enhanced HEMT device 100. The second barrier layer 7 and the p-type cap layer 8 constitute the secondary epitaxial structure 20.

The p-type cap layer 8 may be directly grown on the surface of the second barrier layer 7 through secondary epitaxial growth. It is unnecessary to form the p-type cap layer 8 in the gate region through selective etching as in a conventional process. As described above, the first passivation layer 6 can prevent the acceptor dopant Mg in the p-type cap layer 8 from diffusing to the first barrier layer 5, and avoid etching damage or the like to the first barrier layer 5 due to selective etching.

In some embodiments, in step S4, after the p-type cap layer 8 is formed, annealing is performed to activate the acceptor dopant (for example, the Mg element) in the p-type cap layer 8. Specifically, annealing is performed at a high temperature to activate the acceptor dopant in the p-type cap layer 8.

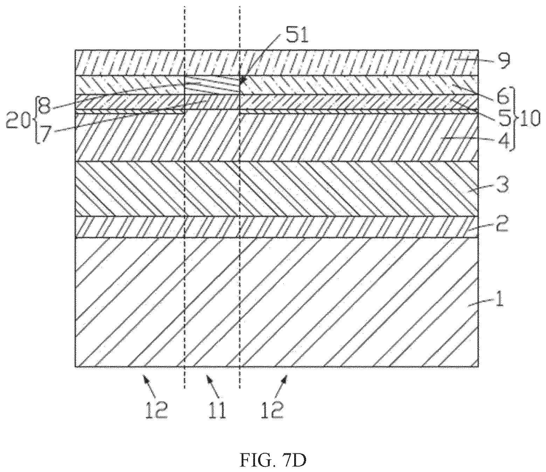

In some embodiments, as shown in FIG. 7D, in step S4, after annealing is performed to activate the acceptor dopant in the p-type cap layer 8, the second passivation layer 9 may be further formed on the surfaces of the first passivation layer 6 and the p-type cap layer 8.

For the material of the second passivation layer 9, refer to the foregoing description. Details are not described herein again.

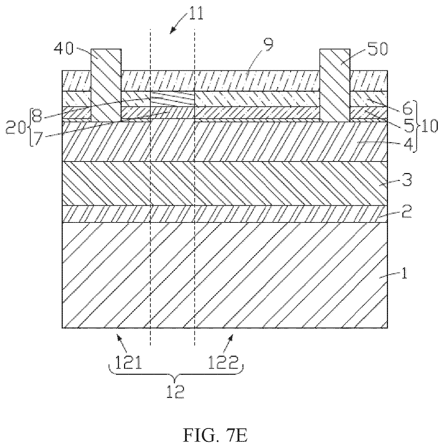

In some embodiments, as shown in FIG. 7E, patterning and selective etching are performed on a structure obtained in step S4. Selective etching is performed on the source-side active region 121 in the active region 12, to remove the second passivation layer 9, the first passivation layer 6, and the first barrier layer 5 at a position of the source. In addition, metal deposition is performed in the etching window to form the source 40. Selective etching is performed on the drain-side active region 122 in the active region 12, to remove the second passivation layer 9, the first passivation layer 6, and the first barrier layer 5 at a position of the drain. In addition, metal deposition is performed in the etching window to form the drain 50.

In some other embodiments, only the second passivation layer 9 and the first passivation layer 6 at the positions of the source and the drain may be etched, so that the source 40 and the drain 50 are directly formed on the surface of the first barrier layer 5.

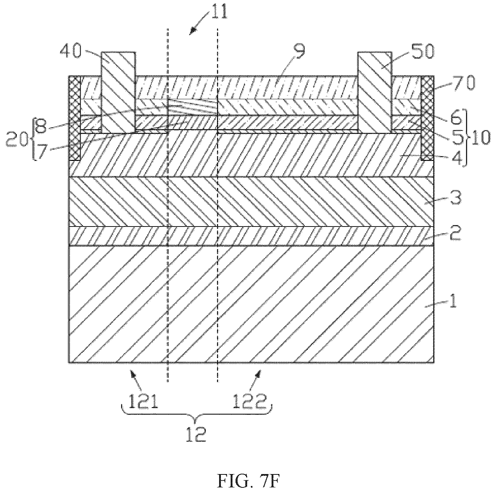

In some embodiments, as shown in FIG. 7F, after the source 40 and the drain 50 are formed, dry etching is performed on an obtained structure to form an isolation layer 70, to isolate the enhanced HEMT device 100.

In some embodiments, with reference to FIG. 3, after device isolation is completed, the second passivation layer 9 in the gate region 11 is removed, to expose the p-type cap layer 8. In addition, metal is deposited on the surface of the p-type cap layer 8 to form the gate 30. The gate 30 is in ohmic contact or Schottky contact.

In a preparing process of the enhanced HEMT device 100 provided in embodiments of this application, the first barrier layer 5 in the active region and the second barrier layer 7 in the gate region are separately formed through two epitaxies, so that the Al component content or thickness of the first barrier layer 5 can be effectively adjusted independently from that of the second barrier layer 7 without mutual interference. The first passivation layer 6 is first introduced on the surface of the first barrier layer 5 in primary epitaxy. The first passivation layer 6 plays a role of a blocking layer, to prevent the acceptor dopant in the p-type cap layer 8 from diffusing outward. It is unnecessary to perform selective etching on the p-type cap layer 8, so that there are no problems such as excessive etching on and etching damage to the first barrier layer 5. The enhanced HEMT device 100 is simple to prepare and easy to implement. This helps improve the performance specifications and reliability of the enhanced HEMT device 100.

It should be noted that the foregoing descriptions are merely specific implementations of this application, but are not intended to limit the protection scope of this application. Any variation or replacement readily figured out by a person skilled in the art within the technical scope disclosed in this application shall be within the protection scope of this application. When no conflict occurs, the implementations of this application and the features in the implementations may be mutually combined. Therefore, the protection scope of this application shall be subject to the protection scope of the claims.

## Claims

1. An enhanced HEMT device, wherein the device is divided into a gate region and an active region in a horizontal direction, and the device comprises:
a substrate;
a primary epitaxial structure, comprising a channel layer on a surface of the substrate and a first barrier layer on a surface of the channel layer corresponding to the active region, wherein the first barrier layer and the channel layer form a heterojunction structure having a two-dimensional electron gas; and
a secondary epitaxial structure, comprising a second barrier layer on a surface of the channel layer corresponding to the gate region and a p-type cap layer on a surface of the second barrier layer, wherein the second barrier layer is different from the first barrier layer.

2. The enhanced HEMT device according to claim 1, wherein the first barrier layer and the second barrier layer have at least one of the following relationships:
an Al component content of the first barrier layer is higher than an Al component content of the second barrier layer; and a thickness of the first barrier layer is greater than a thickness of the second barrier layer.

3. The enhanced HEMT device according to claim 1 or 2, wherein a material of the first barrier layer comprises one or a combination of more of AlGaN, AlInN, InGaN, AlInGaN, ScAlN, and AlN, the Al component content of the first barrier layer ranges from 1% to 40%, and the thickness of the first barrier layer ranges from 1 nm to 50 nm; and
a material of the second barrier layer comprises one or a combination of more of AlGaN, AlInN, InGaN, AlInGaN, ScAlN, and AlN, the Al component content of the second barrier layer ranges from 1% to 30%, and the thickness of the second barrier layer ranges from 1 nm to 40 nm.

4. The enhanced HEMT device according to any one of claims 1 to 3, wherein the device further comprises a first passivation layer on a surface of the first barrier layer.

5. The enhanced HEMT device according to claim 4, wherein a material of the first passivation layer comprises one or a combination of more of SiNₓ, SiO₂, Al₂O₃, AlOₓN_{y}, GaOₓ, AlN, and GaOₓN_{y}.

6. The enhanced HEMT device according to any one of claims 1 to 5, wherein a material of the p-type cap layer comprises one or a combination of more of GaN, AlGaN, InGaN, and AlInGaN; and
a material of the channel layer comprises one or a combination of more of GaN, InN, AlN, and AlGaN.

7. The enhanced HEMT device according to any one of claims 1 to 6, wherein the device further comprises a second passivation layer on a surface of the first passivation layer, and a material of the second passivation layer comprises one or a combination of more of SiNₓ, SiO₂, Al₂O₃, AlOₓN_{y}, GaOₓ, AlN, and GaOₓN_{y}.

8. The enhanced HEMT device according to any one of claims 1 to 7, wherein the primary epitaxial structure further comprises a nucleation layer and a stress buffer layer that are sequentially stacked from bottom to top on the surface of the substrate, and the channel layer is on a surface that is of the stress buffer layer and that is away from the nucleation layer.

9. A preparing method for an enhanced HEMT device, wherein the device is divided into a gate region and an active region in a horizontal direction, and the preparing method comprises:
sequentially forming a channel layer and an intermediate barrier layer from bottom to top on a surface of a substrate;
removing the intermediate barrier layer in the gate region to expose the channel layer, wherein the intermediate barrier layer in the active region constitutes a first barrier layer, the channel layer and the first barrier layer constitute a primary epitaxial structure, and the channel layer and the first barrier layer form a heterojunction structure having a two-dimensional electron gas;
forming a second barrier layer different from the first barrier layer on a surface of the exposed channel layer in the gate region; and
forming a p-type cap layer on a surface of the second barrier layer to obtain the device, wherein the second barrier layer and the p-type cap layer constitute a secondary epitaxial structure.

10. The preparing method according to claim 9, wherein the first barrier layer and the second barrier layer have at least one of the following relationships:
an Al component content of the first barrier layer is higher than an Al component content of the second barrier layer; and a thickness of the first barrier layer is greater than a thickness of the second barrier layer.

11. The preparing method according to claim 9 or 10, wherein before removing the intermediate barrier layer in the gate region, the preparing method further comprises:
forming a first passivation layer on a surface of the intermediate barrier layer; and
removing the first passivation layer in the gate region.

12. The preparing method according to claim 11, wherein a method for forming the first passivation layer comprises metalorganic chemical vapor deposition, chemical vapor deposition, sputter deposition, or atomic layer deposition.

13. The preparing method according to any one of claims 9 to 12, wherein after removing the intermediate barrier layer in the gate region to expose the channel layer, the preparing method further comprises:
repairing the surface of the exposed channel layer.

14. The preparing method according to claim 11, wherein after forming the p-type cap layer, the preparing method further comprises:
performing annealing to activate an acceptor dopant in the p-type cap layer; wherein
after performing annealing to activate the acceptor dopant in the p-type cap layer, the preparing method further comprises:
forming a second passivation layer on surfaces of the first passivation layer and the p-type cap layer.

15. The preparing method according to any one of claims 9 to 14, wherein before forming the channel layer on the surface of the substrate, the preparing method further comprises:
forming a nucleation layer on the surface of the substrate; and
forming a stress buffer layer on a surface of the nucleation layer; wherein
the channel layer is formed on a surface of the stress buffer layer.
